Europäisches Patentamt

European Patent Office

Office européen des brevets

(19)

(11) Veröffentlichungsnummer: **0 392 373**
**A2**

(12) **EUROPÄISCHE PATENTANMELDUNG**

(21) Anmeldenummer: **90106589.6**

(22) Anmeldetag: **06.04.90**

(51) Int. Cl.5: **H01L 31/12**

(30) Priorität: **14.04.89 DE 3912347**

(43) Veröffentlichungstag der Anmeldung:
**17.10.90 Patentblatt 90/42**

(84) Benannte Vertragsstaaten:
**DE FR GB IT NL**

(71) Anmelder: **Siemens Aktiengesellschaft**
**Wittelsbacherplatz 2**
**D-8000 München 2(DE)**

(72) Erfinder: **Kaifler, Erich**
**Veilchenweg 45**
**D-8028 Taufkirchen(DE)**

(54) **Schaltungsanordnung zum potentialfreien Ansteuern eines Feldeffekttransistors.**

(57) Der Empfängerkreis eines Optokopplers (3) liegt zwischen dem Sourceanschluß (S) eines Depletion-FET (1) und einer Sourcespannungsklemme (8). Die Sourcespannungsklemme ist mit dem Gateanschluß (G) des Depletion-FET verbunden. Wird der Optokoppler (3) angesteuert, so wird die Gate-Source-spannung des Depletion-FET (1) Null Volt und er wird leitend gesteuert.

FIG 1

EP 0 392 373 A2

## Schaltungsanordnung zum potentialfreien Ansteuern eines Feldeffekttransistors

Die Erfindung bezieht sich auf eine Schaltungsanordnung zum potentialfreien Ansteuern eines Feldeffekttransistors (FET).

Für viele Zwecke ist es erwünscht, einen Feldeffekttransistor potentialfrei anzusteuern. Das heißt, daß die Source- und Drainanschlußklemmen des FET galvanisch vom Steuerkreis getrennt sein müssen. Dies hat insbesondere dann Bedeutung, wenn die zu schaltende Spannung so hoch ist, daß mehrere FET in Reihe geschaltet werden müssen. Hier ist es erforderlich, alle, auf verschiedenen Sourcepotentialen liegende FET mit einer einzigen Steuerspannungsquelle anzusteuern.

Der Erfindung liegt die Aufgabe zugrunde, eine einfache Schaltungsanordnung zum potentialfreien Ansteuern eines FET anzugeben.

Dieses Ziel wird erreicht durch die Merkmale:

a) Zwischen dem Sourceanschluß eines Depletion-FET und einer Sourcespannungsklemme liegt der Empfängerkreis eines Optokopplers,

b) der Gateanschluß des Depletion-FET ist mit der Sourcespannungsklemme verbunden.

Weiterbildungen der Erfindung sind Gegenstand der Unteransprüche.

Die Erfindung wird anhand einiger Ausführungsbeispiele in Verbindung mit den FIG 1 bis 4 näher erläutert. Es zeigen

FIG 1 ein erstes Ausführungsbeispiel

FIG 2 ein zweites Ausführungsbeispiel der Schaltungsanordnung

FIG 3 ein erstes Beispiel eines Optokopplers und

FIG 4 ein zweites Beispiel eines Optokopplers.

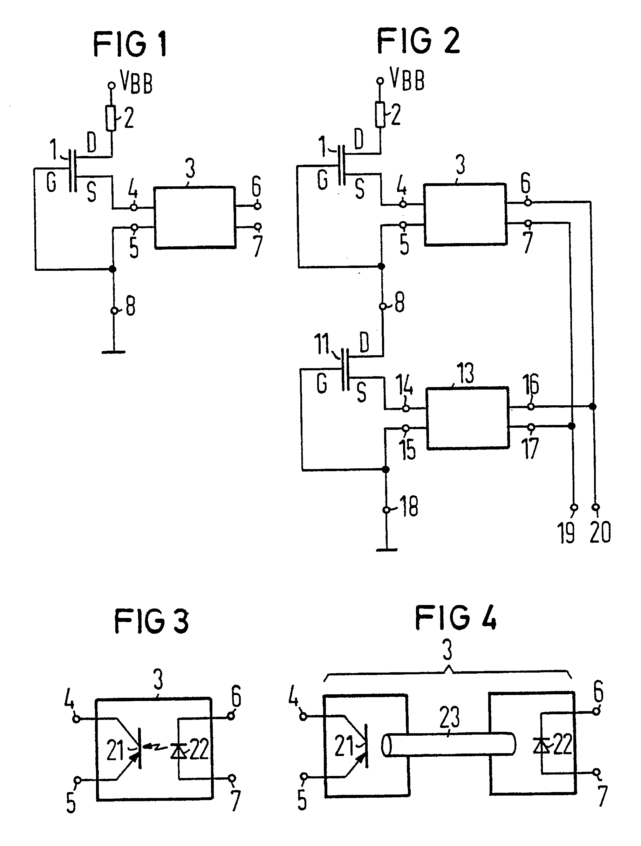

Die Schaltungsanordnung nach FIG 1 enthält einen Depletion-FET 1, dessen Drainanschluß D über eine Last 2 mit einer Versorgungsspannung $V_{BB}$ verbunden ist. Der Sourceanschluß S von 1 ist über den Empfängerkreis eines Optokopplers 3 mit einer Sourcespannungsklemme 8 verbunden. Der Empfängerkreis des Optokopplers 3 ist hier der Einfachheit halber nicht dargestellt, er ist an die Ausgangsklemmen 4, 5 angeschlossen. Der Senderkreis des Optokopplers 3 ist ebenfalls nicht dargestellt, er ist an die Eingangsklemmen 6, 7 angeschlossen. Der Gateanschluß G des Depletion-FET 1 ist mit der Sourcespannungsklemme 8 und mit der Ausgangsklemme 5 des Optokopplers 3 verbunden. Die Sourcespannungsklemme 8 liegt z. B. auf Massepotential.

Liegt an den Eingangsklemmen 6, 7 des Optokopplers 3 keine Spannung an, so hat der Empfängerkreis zwischen den Ausgangsklemmen 4, 5 einen hohen Widerstand. Ist die Spannung $V_{BB}$ positiv, so wird ein Depletion-FET vom n-Kanaltyp verwendet. Das Sourcepotential ist höher als das Gatepotential, der FET 1 ist damit gesperrt.

Wird der Optokoppler 3 durch Anlegen einer Spannung an die Eingangsklemmen 6, 7 aktiviert, so ist der Empfängerkreis zwischen den Ausgangsklemmen 4, 5 niederohmig. Das Gate-Sourcepotential des Depletion-FET 1 ist daher ungefähr gleich Null und der FET 1 wird eingeschaltet.

Die Schaltungsanordnung nach FIG 1 läßt sich in vorteilhafter Weise zu einem Hochspannungsschalter erweitern, wie er in FIG 2 schematisch dargestellt ist. Hier sind zwei der in FIG 1 gezeigten Anordnungen in Reihe geschaltet. Mit der Sourcespannungsklemme 8 ist der Drainanschluß eines zweiten Depletion-FET 11 verbunden. Sein Sourceanschluß S ist über den Empfängerkreis eines Optokopplers 13 mit einer Sourcespannungsklemme 18 verbunden. Diese liegt z. B. auf Massepotential. Der Empfängerkreis des Optokopplers 13 liegt zwischen den Ausgangsklemmen 14, 15. Der Optokoppler 13 hat Eingangsklemmen 16, 17, die mit den Eingangsklemmen 6, 7 des Optokopplers 3 und mit beiden Optokopplern gemeinsamen Eingangsklemmen 19, 20 verbunden sind. Sind die Senderkreise der Optokoppler 3, 13 spannungslos, so sind die FET 1 und 11 gesperrt. Wird eine Steuerspannung an die Klemmen 19, 20 angelegt, werden beide FET leitend gesteuert.

Die Schaltungsanordnung nach FIG 2 läßt sich durch die Reihenschaltung von weiteren Schaltungsanordnungen nach FIG 1 für höhere Spannungen erweitern.

Es empfiehlt sich, für Schaltungsanordnungen mit mehr als einem FET avalanchefeste Depletion-FET zu verwenden. Dies empfiehlt sich deswegen, weil die Schaltzeiten der FET nie genau gleich sind. Ein avalanchefester FET ist nun in der Lage, für eine kurze Zeit den vollen Laststrom bei voller Drain-Sourcespannung zu übernehmen. Spätestens nach Ablauf dieser Zeit muß sichergestellt sein, daß er leitend gesteuert ist. Die genannten avalanchefesten FET sind im Handel erhältlich und werden daher nicht gesondert erläutert.

Die Optokoppler 3, 13 können wie üblich aus einem Fototransistor 21 und einer lichtemittierenden Diode (LED) 22 bestehen, wie in FIG 3 dargestellt. Anstelle eines Fototransistors kann für Wechselspannungsanwendungen auch ein Fotothyristor verwendet werden. Die Isolationsstrecke zwischen dem Fototransistor 21 und der LED 22 muß für die Betriebsspannung $V_{BB}$ bemessen sein. Reicht die Isolationsstrecke eines üblichen Optokopplers für hohe Betriebsspannungen nicht aus, so läßt sich die in FIG 4 gezeigte Ausführung eines Optokopplers verwenden. Hierbei ist der Fototransistor 21 mit einer Lichtquelle, z. B. der LED 22 über einen Lichtleiter oder Lichtwellenleiter 23 gekoppelt. Die Isolierstrecke wird hier dann im wesentlichen durch die Länge des Lichtleiters 23 bestimmt.

**Ansprüche**

1. Schaltungsanordnung zum potentialfreien Ansteuern eines FET, **gekennzeichnet durch** die Merkmale:

a) Zwischen dem Sourceanschluß (S) eines Depletion-FET (1) und einer Sourcespannungsklemme (8) liegt der Empfängerkreis eines Optokopplers (3),

b) der Gateanschluß (G) des Depletion-FET (1) ist mit der Sourcespannungsklemme (8) verbunden.

2. Schaltungsanordnung **gekennzeichnet durch** die Serienschaltung mehrerer Schaltungsanordnungen nach Anspruch 1.

3. Schaltungsanordnung nach Anspruch 1 oder 2, **dadurch gekennzeichnet,** daß der Optokoppler (3) aus einem Fototransistor (21) und mindestens einer lichtemittierenden Diode (22) besteht.

4. Schaltungsanordnung nach Anspruch 2, **dadurch gekennzeichnet,** daß der Optokoppler (3) aus einem Fototransistor (21), einem Lichtleiter (23) und einer Lichtquelle (22) besteht.

5. Schaltungsanordnung nach einem der Ansprüche 1 bis 4, **dadurch gekennzeichnet,** daß der Depletion-FET (1, 11) avalanchefest ist.

# FIG 1

# FIG 2

# FIG 3

# FIG 4